# NEUE EUROPÄISCHE PATENTSCHRIFT

(11) **EP 0 896 504 B2**
(45) Veröffentlichungstag und Bekanntmachung des Hinweises auf die Entscheidung über den Einspruch: **12.03.2008**
(45) Hinweis auf die Patenterteilung: 02.04.2003
(21) Anmeldenummer: 98113723.5
(22) Anmeldetag: 23.07.1998
(51) Int. Cl.: H05K 7/14

(54) **Elektrisches oder elektronisches Gerät**
Electrical or electronic apparatus
Appareil électrique ou électronique

(30) Priorität: 05.08.1997 DE 29713960 U
(43) Veröffentlichungstag der Anmeldung: 10.02.1999
(73) Patentinhaber: PHOENIX CONTACT GmbH & Co. Kg, 32825 Blomberg (DE)
(72) Erfinder: Feye-Hohmann, Jürgen, 32756 Detmold (DE)
(74) Vertreter: Gesthuysen, von Rohr & Eggert

(56) Entgegenhaltungen:
- EP-A- 0 661 915
- EP-A2- 0 236 711
- EP-B1- 0 364 618
- EP-B1- 0 680 114
- WO-A1-98/42045
- DE-A- 3 603 750
- DE-A- 4 402 002
- DE-A- 19 651 961
- DE-C1- 4 140 611
- DE-C1- 4 438 804
- DE-C2- 3 922 551
- DE-U1- 29 606 759
- US-A- 3 891 295
- US-A- 4 472 764
- US-A- 4 477 862

## Beschreibung

Die Erfindung betrifft ein elektrisches oder elektronisches Gerät zum Aufsetzen auf eine Tragschiene, mit einem Gehäuse, mit wenigstens einer im Gehäuse angeordneten Leiterplatte und mit in Tragschienenlängsrichtung weisenden Buskontakten für eine Daten- und/oder Energiebusverbindung mit benachbarten, auf die Tragschiene aufgesetzten und korrespondierende Buskontakte aufweisenden elektrischen oder elektronischen Geräten.

Ein elektrisches oder elektronisches Gerät der eingangs genannten Art ist bereits aus der DE 44 02 002 A1 bekannt. Bei dem bekannten Elektronikgerät ist es so, daß dieses auf eine handelsübliche Tragschiene aufrastbar ist und beim Aufrasten automatisch mit benachbarten Elektronikgeräten durchkontaktiert wird. Auf diese Weise ergibt sich über die durchkontaktierten Elektronikgeräte eine Busverbindung.

Probleme ergeben sich bei der bekannten Konstruktion in dem Fall, wenn die Leiterplatte in dem elektrischen oder elektronischen Gerät defekt ist und das elektrische oder elektronische Gerät zur Reparatur oder Austauschzwecken aus dem Verbund herausgenommen werden muß. Dies führt automatisch zu einer Unterbrechung der Datenund/oder Energiebusverbindung.

Aus der EP 0 661 915 A1 ist ein elektrisches oder elektronisches Gerät zum Aufsetzen auf eine Tragschiene bekannt, bei dem das Gehäuse zweiteilig ausgebildet ist, wobei im Oberteil des Gehäuses eine erste Leiterplatte in entsprechenden Führungen gehalten ist und auf dem Unterteil des Gehäuses eine zweite Leiterplatte mit zwei darauf angeordneten und über die Leiterplatte miteinander verbundenen Buskontakten befestigt ist. Zur Verbindung der ersten Leiterplatte mit den Buskontakten ist sowohl an der ersten Leiterplatte als auch auf der zweiten Leiterplatte ein Stecker angeordnet. Bei diesem bekannten Gerät ist die Kontaktierung der ersten Leiterplatte somit relativ aufwendig und umständlich realisiert. Ein elektronisches Gerät gemäß dem Oberbegriff der Patentansprüche 1 und 15 ist aus der EP 0 364 618 B1 bekannt.

Aufgabe der Erfindung ist es daher, ein elektronisches oder elektronisches Gerät der eingangs genannten Art zur Verfügung zu stellen, bei dem ein Austausch der Leiterplatte besonders einfach möglich ist, ohne daß es zu einer Unterbrechung der Datenund/oder Energiebusverbindung kommt. Dabei soll das Ein- bzw. Ausschwenken des Sockelteils bzw. eine einfache Montage der Buskontakte im Leiterplattenaufnahmekörper ermöglicht werden.

Nach der Erfindung wird die Aufgabe gemäß einer ersten Alternative durch ein elektrisches oder elektronisches Gerät mit den Merkmalen des Patentanspruchs 1 und gemäß einer zweiten Alternative durch ein elektrisches oder elektronisches Gerät mit den Merkmalen des Patentanspruchs 15 gelöst. Die beiden erfindungsgemäßen Ausgestaltungen des elektrischen oder elektronischen Gerätes bieten aufgrund der Teilbarkeit des Gehäuses die Möglichkeit, in einfacher Weise eine defekte Leiterplatte auszutauschen, ohne daß die Busverbindung unterbrochen wird. Die Daten- und/oder Energiebusverbindung wird bei der Erfindung ausschließlich über die in den Sockelteilen vorgesehenen Buskontakte realisiert, wobei die Sockelteile auch nach Abnahme des Oberteils mit der oder ohne die Leiterplatte auf der Tragschiene verbleiben. Die erfindungsgemäße Ausgestaltung bietet außerdem eine gewisse Modularität, da die Oberteile unterschiedlich breit sein können, nämlich um das n-fache der Breite eines Sockelteils. Bei der ersten alternativen Ausgestaltung der Erfindung ist vorgesehen, daß das Gehäuse zumindest ein auf die Tragschiene aufzusetzendes Sockelteil und ein mit dem Sockelteil lösbar verbindbares Oberteil aufweist, wobei am Sockelteil die Leiterplattenaufnahme und die Buskontakte vorgesehen sind, und wobei das Sockelteil auf die Tragschiene aufschwenkbar ist. Erfindungsgemäß ist dabei vorgesehen, daß bei abgenommenem Oberteil die Leiterplatte in der Leiterplattenaufnahme angeordnet ist , daß der eine Buskontakt auf der einen Seite als überstehender Messerkontakt und der andere Buskontakt auf der anderen Seite als doppelschenklige Kontaktaufnahme für den Messerkontakt ausgebildet sind und daß am Sockelteil oder an der Leiterplattenaufnahme in die Kontaktaufnahme mündende, etwa vertikal verlaufende Schlitze vorgesehen sind, um ein Ein- und Ausschwenken eines Sockelteils in die bzw. aus der Daten- und/oder Energieverbindung zu ermöglichen.

Damit es nicht zu einem unbeabsichtigten Lösen des Oberteils vom Sockelteil kommt, ist eine erste Verriegelung zwischen diesen beiden Bauteilen vorgesehen. Diese ist zweckmäßigerweise als Rastverbindung ausgebildet. Bei einer vorteilhaften Ausführungsform ist am Oberteil ein federnder Rastarm vorgesehen, während am Sockelteil zum Rastarm korrespondierende Rasthaken vorgesehen sind.

Erfindungsgemäß ist weiterhin vorgesehen, daß das Oberteil auf das Sockelteil aufschwenkbar ist, wobei die erste Verriegelung einen von der Außenseite des Gehäuses manuell zu betätigenden Griff- oder Eingriffsabschnitt am Rastarm zum Lösen des Oberteils vom Sockelteil aufweist. Das Lösen des Oberteils vom Sockelteil kann bei dieser Ausführungsform extrem einfach durch Lösen nur einer Rastverbindung realisiert werden. Über den Griff- oder Eingriffsabschnitt kann der Rastarm manuell per Hand oder mit Hilfe eines Werkzeugs, beispielsweise eines Schraubendrehers, geöffnet werden.

Statt der Ausbildung der ersten Verriegelung als Rastverbindung kann auch vorgesehen sein, daß das Oberteil lediglich reibschlüssig auf das Sockelteil aufgeschoben ist. Diese Ausgestaltung bietet sich insbesondere dann an , wenn entsprechend der zweiten erfindungsgemäßen Alternative lediglich das Oberteil vom Sockelteil abnehmbar ist und die Leiterplatte bei abgenommenem Oberteil in der Leiterplattenaufnahme am Sockelteil verbleibt.

Um einerseits das Sockelteil in einfacher Weise mit der Tragschiene verbinden zu können und um andererseits ein unbeabsichtigtes Lösen des Sockelteils von der Tragschiene zu verhindern, ist weiterhin vorgesehen, daß das Sockelteil auf die Tragschiene aufschwenkbar ist. Dabei ist der eine Buskontakt auf der einen Seite des Gerätes als überstehender Messerkontakt und der andere Buskontakt auf der anderen Seite als doppelschenklige Kontaktaufnahme für den Messerkontakt ausgebildet. Am Sockelteil oder in der Leiterplattenaufnahme sind in die Kontaktaufnahmen mündende, etwa vertikal verlaufende Schlitze vorgesehen, so daß das Sockelteil in die bzw. aus der Daten- und/oder Energiebusverbindung ein- bzw. ausgeschwenkt werden kann.

Damit beim Lösen bzw. Entriegeln des Oberteils vom Sockelteil das Sockelteil nicht mit gelöst wird, was im schlimmsten Falle eine Unterbrechung der Daten- und/oder Energiebusverbindung bedeuten würde, ist eine zweite insbesondere rastbare Verriegelung zur lösbaren Verbindung des Sockelteils mit der Tragschiene vorgesehen. Wichtig ist hierbei, daß die zweite Verriegelung völlig unabhängig von der ersten Verriegelung ist, so daß ein Lösen der ersten Verriegelung nicht unbeabsichtigterweise zu einem Lösen auch der zweiten Verriegelung führen kann. Günstigerweise weist die zweite Verriegelung hierzu einen federbelasteten Riegel am Sockelteil zum einseitigen Verriegeln an der Tragschiene auf.

Vorzugsweise ist der Riegel dabei im Bereich der Unterseite des Sockelteils angeordnet und damit von außen her an sich nicht zugänglich. Zum Öffnen der zweiten Verriegelung ist am Riegel eine Betätigungsöffnung und auf der Oberseite des Sockelteils eine Einführöffnung für ein Werkzeug, beispielsweise einen Schraubendreher, vorgesehen, wobei die Betätigungsöffnung derart versetzt zur Einführöffnung angeordnet ist, daß beim Einführen des Werkzeugs in die Betätigungs- und Einführöffnung der Riegel entgegen der Federbelastung bewegt und das Sockelteil freigegeben wird. Dabei ist es besonders zweckmäßig, daß die Einführöffnung am Sockelteil nur bei abgenommenem Oberteil zugänglich ist. Durch die vorgenannte Ausgestaltung ist sichergestellt, daß die zweite Verriegelung keinesfalls vor der ersten Verriegelung gelöst werden kann, da zunächst das Oberteil abgenommen werden muß, um an die Oberseite des Sockelteils und damit an die Einführöffnung zu gelangen.

Damit die Leiterplatte im Gehäuse richtig angeordnet ist, d. h. in jedem Falle ordnungsgemäß in der am Sockelteil vorgesehenen Leiterplattenaufnahme mit den dort vorgesehenen Kontakten kontaktiert, und damit außerdem sichergestellt ist, daß die Leiterplatte entsprechend der ersten erfindungsgemäßen Alternative beim Abnehmen des Oberteils vom Sockelteil mit abgezogen wird, ist erfindungsgemäß außerdem vorgesehen. daß in der Leiterplatte und im Oberteil jeweils korrespondierende Öffnungen zum Einstecken wenigstens einer Fixiereinrichtung von der Außenseite des Gehäuses vorgesehen sind. Zur Erzielung einer guten Verbindung reicht es dabei aus, die Fixiereinrichtung lediglich in die Leiterplatte einzustecken. Die Fixierung erfolgt vorliegend also ausschließlich durch das Einstecken der Fixiereinrichtung von außen her in die Öffnungen im Oberteil und der Leiterplatte. Dieses Einstecken ist nur dann möglich, wenn die jeweiligen Öffnungen im Oberteil und der Leiterplatte ausgefluchtet sind. Bei ausgefluchteten Öffnungen befindet sich die Leiterplatte dann in der gewünschten Einbau- und Kontaktierungsposition.

Um eine sichere Verbindung der Leiterplatte zum Gehäuse zu erzielen, weist die Fixiereinrichtung wenigstens einen, vorzugsweise jedoch zwei Einsteckschenkel auf, wobei am Einsteckschenkel wenigstens eine Verdickung vorgesehen ist, über die sich ein guter Reibschluß mit der korrespondierenden Öffnung in der Leiterplatte erzielen läßt.

Neben der Fixierungsfunktion kann die Fixiereinrichtung aber auch einen weiteren Zweck erfüllen, nämlich zum elektrischen Anschluß von Zuführungskontakten dienen. Dies kann ohne weiteres bei entsprechender Ausbildung über die Fixiereinrichtung erfolgen. Zu diesem Zweck weist die Fixiereinrichtung wenigstens ein Klemmenelement in Form einer Anschlußklemme auf, das günstigerweise von einer Stirnseite des Oberteils oder aber von der Oberseite des Oberteils her zugänglich ist. In diesem Falle kontaktiert der Einsteckschenkel mit einer Leiterbahn auf der Leiterplatte. Das elektrische oder elektronische Gerät hat dann auch die Funktion einer anreihbaren Klemme.

Damit die Fixiereinrichtung nicht über das elektrische oder elektronische Gerät seitlich übersteht, ist bei einer vorteilhaften Ausführungsform vorgesehen, daß die Fixiereinrichtung in einer korrespondierenden Aufnahme im Oberteil aufgenommen ist. Wenn bei dieser Ausführungsform die Fixiereinrichtung wenigstens ein Klemmenelement aufweist, also zum Anschluß von Zuführungskontakten dient, ist im Oberteil wenigstens eine Anschlußöffnung zum Einführen des Zuführungskontaktes in das Klemmenelement und wenigstens eine Betätigungsöffnung zur Betätigung des Klemmenelementes vorgesehen.

Damit die Fixiereinrichtung während des Gebrauchs des Klemmenelemtens keinen mechanischen Beanspruchungen unterliegt, die sich auf die Leiterplatte übertragen könnten, weist die Fixiereinrichtung einen aus dem Klemmenelement herausragenden Schenkel auf, von dem der Einsteckschenkel absteht. An dem Schenkel ist nun eine Stufe vorgesehen, während sich in der Aufnahme ein korrespondierender stufenförmiger Schlitz befindet, in dem die Stufe des Schenkels am Gehäuse anliegt. Eine etwaige Zug- oder Druckbelastung wird somit vom Gehäuse aufgenommen und nicht auf die Leiterplatte übertragen.

Damit die Fixiereinrichtung nicht aus dem elektrischen oder elektronischen Gerät herausfallen kann, ist außerdem eine Abdeckung für die Aufnahme vorgesehen, die lösbar mit dem Gehäuse verbindbar, vorzugsweise verrastbar ist.

Um den Anwendungsbereich des erfindungsgemäßen Gerätes noch mehr zu erweitern, ist weiterhin am Oberteil, insbesondere an wenigstens einer Stirnseite zumindest ein mit der Leiterplatte elektrisch verbundener Steckeranschluß vorgesehen. Über den Steckeranschluß lassen sich Zusatzmodule oder andere elektrische oder elektronische Geräte mit dem erfindungsgemäßen Gerät koppeln.

Für verschiedene Anwendungsfälle sind unterschiedliche Arten oder Ausgestaltungen von Buskontakten für die Daten- und/oder Energiebusverbindung erforderlich. Damit nicht für jeden Busverbindungstyp unterschiedliche Sockelteile erforderlich sind, ist gemäß einer erfindungsgemäßen Ausgestaltung der Erfindung ein die Leiterplattenaufnahme aufweisender, separater und auf dem Sockelteil zu befestigender Leiterplattenaufnahmekörper aus isolierendem Material vorgesehen, in den die Buskontakte eingesetzt sind. Diese Ausgestaltung ermöglicht es, stets gleiche Sockelteile zu verwenden, wobei bedarfsweise lediglich unterschiedliche Leiterplattenaufnahmekörper verwendet werden müssen. Da es sich bei dem Leiterplattenaufnahmekörper um ein an sich separates Bauteil handelt, können hierin die Buskontakte ohne weiteres vormontiert werden.

Um eine einfache Montage der Buskontakte im Leiterplattenaufnahmekörper zu ermöglichen, ist dieser zumindest zweiteilig ausgebildet und weist ein erstes Gehäuseteil und ein damit fest zu verbindendes zweites Gehäuseteil auf. Dabei sind zumindest in einem Gehäuseteil quer zur Leiterplattenebene gerichtete Einsetzöffnungen zum form- und/oder reibschlüssigen Einsetzen der Buskontakte vorgesehen. Hierdurch wird gewährleistet, daß die Buskontakte bei der Montage nicht unbeabsichtigter Weise aus dem betreffenden Gehäuseteil herausfallen. In den Einsetzöffnungen sind die benachbarten Buskontakte gegeneinander isoliert.

Bei einer Ausgestaltung der Erfindung sind in Verlängerung der Einsetzöffnungen an dem ersten Gehäuseteil langgestreckte, über das Sockelteil überstehende Verlängerungen, in denen sich die einen Buskontakte befinden, vorgesehen, während sich am zweiten Gehäuseteil korrespondierende Öffnungen befinden, in denen die anderen Buskontakte angeordnet sind. Die Buskontakte ragen hierbei aus den Verlängerungen und den Öffnungen nicht heraus und sind lediglich von der Vorderseite der Verlängerungen und der Öffnungen zugänglich. Hierdurch wird sichergestellt, daß unbeabsichtigte Kurzschlüsse zwischen den Buskontakten nicht auftreten können. Im Gegensatz zu der eingangs beschriebenen Ausführungsform, bei der die Sockelteile derart ausgebildet sind, daß sich beim Aufschwenken auf die Tragschiene direkt eine Kontaktierung mit benachbarten Sockelteilen ergibt, sind die Verlängerungen und Öffnungen bei der zuvor genannten Ausführungsform derart ausgebildet, daß sich die Daten- und/oder Energiebusverbindung nur durch Ineinanderschieben benachbarter Sockelteile in Tragschienenlängsrichtung ergibt. Letztlich wird bei dieser Ausführungsform einerseits sichergestellt, daß es keinesfalls zu einem unbeabsichtigten Unterbrechen der Busverbindung kommt, und andererseits, daß unbeabsichtigte Fremdkontakierungen der Buskontakte nicht auftreten können.

Die Leiterplattenaufnahme weist in an sich bekannter Weise einen Leiterplattenaufnahmeschlitz zur Anordnung der Leiterplatte auf. Der Leiterplattenaufnahmeschlitz wird dabei von zwei parallel zueinander verlaufenden Wandungen gebildet. Zur Erleichterung der Montage der Kontaktelemente mit den Buskontakten ist dabei eine Wandung am ersten Gehäuseteil vorgesehen, während die andere Wandung am zweiten Gehäuseteil vorgesehen ist. Dieser Ausgestaltung ermöglicht es, Buskontakte zu verwenden, mit denen einteilig ein Leiterplattenaufnahmekontakt ausgebildet ist. Die Montage der Buskontakte erfolgt dann derart, daß die einen Buskontakte beispielsweise in das erste Gehäuseteil eingeschoben werden. Der Leiterplattenaufnahmekontakt liegt dann in dem geöffneten Leiterplattenaufnahmeschlitz etwa an der Wandung an. Anschließend wird dann das zweite Gehäuseteil auf die anderen Buskontakte aufgesetzt und die beiden Gehäuseteile werden fest gegeneinander gedrückt, so daß der Leiterplattenaufnahmekörper geschlossen wird. Es ergibt sich dann der Leiterplattenaufnahmeschlitz, in dem der Leiterplattenaufnahmekontakt angeordnet ist.

Um zu verhindern, daß sich die beiden Gehäuseteile unbeabsichtigter Weise wieder lösen, ist eine Rastverbindung zur lösbaren Verbindung des ersten Gehäuseteils mit dem zweiten Gehäuseteil vorgesehen. Bei einer besonders zweckmäßigen Ausgestaltung der Rastverbindung sind an den seitlichen Stirnseiten des Leiterplattenaufnahmekörpers jeweils wenigstens ein federnder Rastarm mit Rasthaken und zum Rasthaken korrespondierende Rastvorsprünge vorgesehen.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst.

Es zeigt
- Fig. 1: eine perspektivische Ansicht eines auf eine Tragschiene aufgesetzten erfindungsgemäßen elektrischen oder elektronischen Gerätes,
- Fig. 2: eine perspektivische Ansicht einer anderen Ausführungsform eines erfindungsgemäßen elektrischen oder elektronischen Gerätes,
- Fig. 3: eine perspektivische Ansicht von Sockelteilen von erfindungsgemäßen elektrischen oder elektronischen Geräten,
- Fig. 4: eine andere perspektivische Ansicht von Sockelteilen von erfindungsgemäßen elektrischen oder elektronischen Geräten,
- Fig. 5: eine Vorderansicht im Schnitt eines Teils eines erfindungsgemäßen elektrischen oder elektronischen Gerätes,
- Fig. 6: eine Vorderansicht im Schnitt einer anderen Ausführungsform eines erfindungsgemäßen elektrischen oder elektronischen Gerätes,
- Fig. 7: eine perspektivische Ansicht der Art der Fixierung der Leiterplatte eines erfindungsgemäßen elektrischen oder elektronischen Gerätes unter Weglassung des Gehäuses,
- Fig. 8: eine perspektivische Ansicht von zwei Fixiereinrichtungen zur Fixierung der Leiterplatte,
- Fig. 9: eine perspektivische Ansicht eines Teils des Gehäuses eines erfindungsgemäßen elektrischen oder elektronischen Gerätes,
- Fig. 10: eine Vorderansicht, teilweise im Schnitt, einer weiteren Ausführungsform eines erfindungsgemäßen elektrischen oder elektronischen Gerätes,
- Fig. 11: eine Schnittansicht des Gerätes aus Fig. 10 entlang der Schnittlinie XI - XI aus Fig. 10,
- Fig. 12: eine Seitenansicht des Gerätes aus Fig. 10,
- Fig. 13: eine perspektivische Ansicht eines Leiterplattenaufnahmekörpers ohne Leiterplatte,

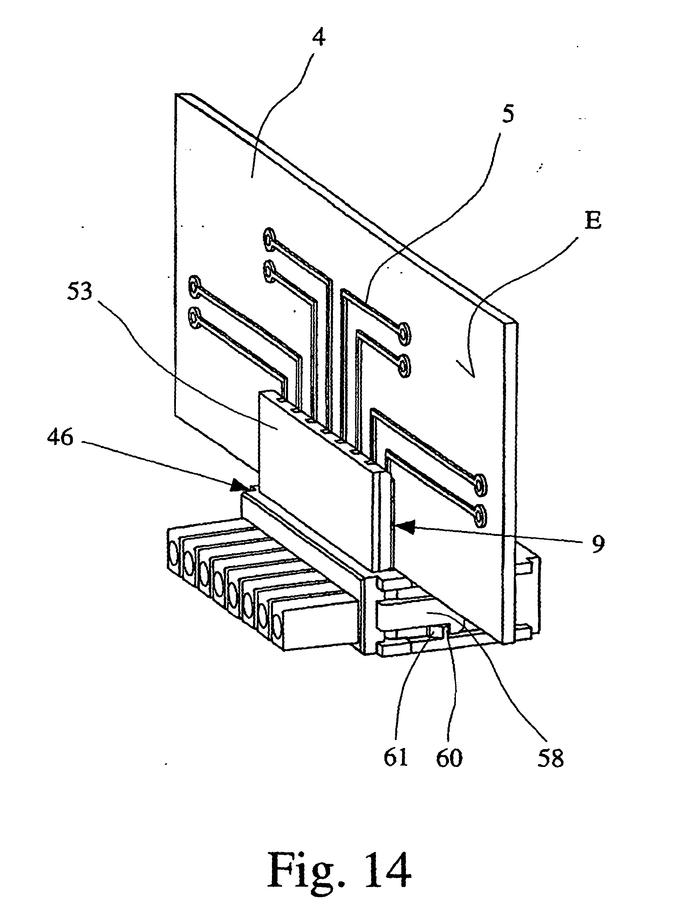

- Fig. 14: eine perspektivische Ansicht eines Leiterplattenaufnahmekörpers mit eingesetzter Leiterplatte und
- Fig. 15: eine perspektivische Explosionsdarstellung des Leiterplattenaufnahmekörpers aus Fig. 13.

In den Figuren ist ein elektrisches oder elektronisches Gerät 1 dargestellt, das zum Aufsetzen auf eine als Hutschiene ausgebildete Tragschiene 2 vorgesehen ist. Das elektrische oder elektronische Gerät 1 selbst weist ein Gehäuse 3 auf, das aus einem isolierenden Material, insbesondere Kunststoff, besteht. Im Gehäuse 3 befindet sich eine Leiterplatte 4. Die Leiterplatte 4 ist in an sich bekannter Weise mit Leiterbahnen 5 ggf. auf beiden Leiterplattenseiten und mit nicht näher dargestellten elektronischen Bauteilen versehen. Des weiteren weist das elektrische oder elektronische Gerät 1 in Tragschienenlängsrichtung R weisende, als Messerkontakte ausgebildete Buskontakte 6a auf der einen Seite 11a und korrespondierende, als Kontaktaufnahmen ausgebildete Buskontakte 6b auf der anderen Seite 11b für eine Daten- und/oder Energiebusverbindung zur Kontaktierung von benachbarten, auf die Tragschiene 2 aufgesetzten und korrespondierende Buskontakte aufweisenden weiteren Geräten auf. Jeder einzelne Buskontakt 6a ist mit einem Buskontakt 6b einstückig ausgebildet. Es handelt sich also um ein Kontaktelement. Benachbarte Kontaktelemente sind gegeneinander isoliert.

Elektrische oder elektronische Geräte 1 der zuvor beschriebenen Art können aufgrund ihrer Ausbildung auf einer Tragschiene 2 aneinandergereiht werden, wobei sich über die jeweiligen Buskontakte 6a, 6b eine Daten- und/oder Energiebusverbindung ergibt. Das dargestellte elektrische oder elektronische Gerät 1 ist außerdem in Art einer anreihbaren Klemme ausgebildet und insbesondere für den Ex-Schutzbereich geeignet.

Wesentlich ist nun, daß das Gehäuse 3 zumindest zweiteilig ausgebildet ist. Im dargestellten Ausführungsbeispiel weist das Gehäuse 3 ein die Leiterplatte 4 aufnehmendes Oberteil 7 und ein die Buskontakte 6a, 6b aufweisendes Sockelteil 8 auf. Zur Kontaktierung der Leiterplatte 4 weist das Sockelteil 8 eine Leiterplattenaufnahme 9 auf, die über die Oberseite 10 des Sockelteils 8 übersteht. Die einzelnen Kontakte in der Leiterplattenaufnahme 9 sind jeweils mit den korrespondierenden Buskontakten 6a, 6b in den Seiten 11a, 11b des Sockelteils 8 verbunden.

Bei einer nicht dargestellten Ausführungsform, bei der ebenfalls von der Zweiteiligkeit des Gehäuses Gebrauch gemacht wird, ist vorgesehen, daß lediglich das Oberteil als solches vom Sockelteil abnehmbar ist. Bei abgenommenem Oberteil ist die Leiterplatte in der Leiterplattenaufnahme angeordnet und kann aus dieser bedarfsweise herausgenommen werden. Nach Austausch oder Reparatur der Leiterplatte kann das Oberteil wieder aufgesetzt werden.

Zur lösbaren Verbindung des Oberteils 7 mit dem Sockelteil 8 ist eine erste Verriegelung vorgesehen, die als Rastverbindung ausgebildet ist. Hierzu weist die erste Verriegelung einen federnden Rastarm 12 auf, der am Oberteil 7 vorgesehen ist. Der Rastarm 12, der nach unten hin über das Oberteil 7 übersteht, weist einen Rastabschnitt 13 auf, der mit zwei korrespondierenden Rasthaken 14, 15, die an der Stirnseite 16 des Sockelteils 8 vorgesehen sind, zusammenwirken. Die Rasthaken 14, 15 sowie der Rastabschnitt 13 weisen jeweils Auflaufschrägen auf, um das Aufrasten zu erleichtern. Die beiden Rasthaken 14, 15 sind voneinander beabstandet, so daß der Rastarm im verrasteten Zustand zwischen den Rasthaken 14, 15 liegt. Zum Öffnen der Rastverbindung der ersten Verriegelung ist am Ende des Rastarms 12 ein Eingriffsabschnitt in Form einer Tasche 17 vorgesehen, in die ein Werkzeug, wie beispielsweise ein Schraubendreher, eingesetzt und mit dessen Hilfe der Rastarm 12 ausgefedert werden kann. Während an der einen Stirnseite des Gehäuses 3 die Rastverbindung vorgesehen ist, befindet sich an der anderen Stirnseite am Oberteil 7 ein nicht dargestellter Aufnahmeschlitz für einen korrespondierenden Vorsprung 18 am Sockelteil 8, so daß das Oberteil 7 auf das Sockelteil 8 aufschwenkbar ist.

Statt der zuvor beschriebenen Rastverbindung kann grundsätzlich aber auch jede andere Art der lösbaren Verbindung zwischen dem Oberteil und dem Sockelteil gewählt werden, so beispielsweise eine reibschlüssige Verbindung.

Zur lösbaren Verbindung des Sockelteils 8 mit der Tragschiene 2 ist eine zweite Verriegelung vorgesehen. Wie das Oberteil 7 auf das Sockelteil 8 so ist auch das Sockelteil 8 auf die Tragschiene 2 aufschwenkbar. Zu diesem Zweck ist an der Unterseite 20 des Sockelteils 8 ein nicht näher dargestellter Schlitz zum Eingriff des korrespondierenden Vorsprungs 2a der Tragschiene 2 vorgesehen. Gegenüberliegend der Schwenkverbindung befindet sich am Sockelteil 8 ein federbelasteter Riegel 19, der zum einseitigen Untergreifen der Tragschiene 2 bzw. des korrespondierenden Vorsprungs 2b der Tragschiene 2 dient.

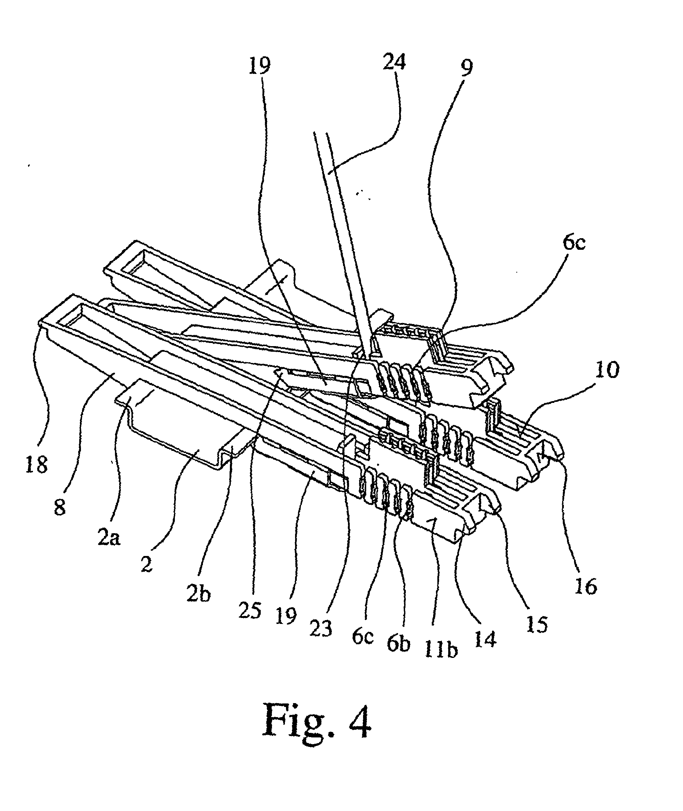

Um das Aufschwenken des Sockelteils 8 auf die Tragschiene 2 bereits in der vorgesehenen Einbaustellung zu ermöglichen, sind am Sockelteil 8 in die als Kontaktaufnahmen ausgebildete Buskontakte 6b mündende, etwa vertikal verlaufende Schlitze 6c vorgesehen, die ein Ein- bzw. Ausschwenken des Sockelteils 8 in die bzw. aus der Daten- und/oder Energiebusverbindung ermöglichen. Wie sich insbesondere aus Fig. 4 ergibt, erweitern sich die Schlitze 6c nach oben hin, so daß ein sicheres Einschwenken der als Messerkontakte ausgebildeten Buskontakte 6a gewährleistet ist.

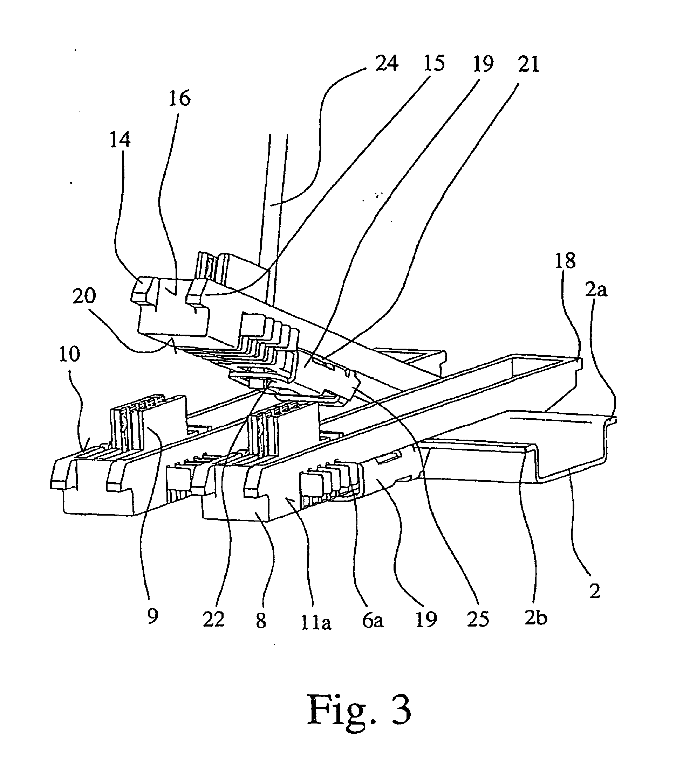

Der Riegel 19 ist an sich an der Unterseite 20 des Sockelteils 8 angeordnet. Die Form des Riegels 19 ist etwa U-förmig, wobei sich der Riegel 19 über die gesamte Unterseite 20 des Sockelteils 8 erstreckt. Die oberen Enden der U-Schenkel sind aufeinander zu abgewinkelt und greifen jeweils in einen korrespondierenden Schlitz 21 an den Seiten 11a, 11b am Sockelteil 8 ein. Hierdurch ist der Riegel 19 unverlierbar am Sokkelteil 8 gehalten. Am Riegel 19 befindet sich eine Betätigungsöffnung 22, während im Sockelteil 8 eine durchgehende, von der Oberseite 10 her zugängliche Einführöffnung 23 für ein Werkzeug 24, wie einen Schraubendreher, vorgesehen ist (vgl. insbesondere Fig. 3 und 4). Die Einführöffnung 23 ist dabei nur zugänglich, wenn das Oberteil 7 vom Sockelteil 8 abgenommen worden ist. Im Verriegelungszustand, in dem der Riegel 19 mit seinem Verriegelungsabschnitt 25 den Vorsprung 2b der Tragschiene 2 untergreift, sind die Betätigungsöffnung 22 und die Einführöffnung 23 versetzt zueinander angeordnet, wobei ein Einführen des Werkzeugs 24 in die Betätigungsöffnung 22 aber noch möglich ist. Durch ein weiteres Einführen des Werkzeugs 24 öffnet sich die Betätigungsöffnung 22 in die Einführöffnung 23, wobei der Riegel 19 entgegen der Federbelastung bewegt wird bis der Verriegelungsabschnitt 25 den entsprechenden Vorsprung 2b der Tragschiene 2 nicht mehr untergreift und das Sockelteil 8 damit von der Tragschiene 2 abgeschwenkt werden kann.

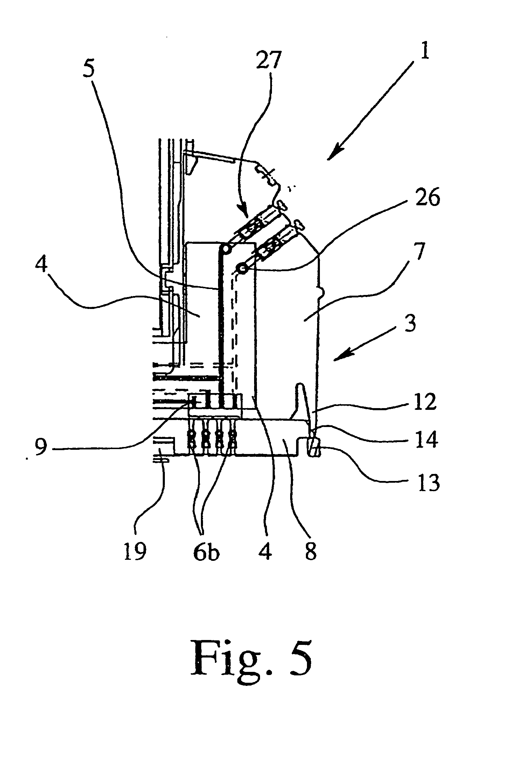

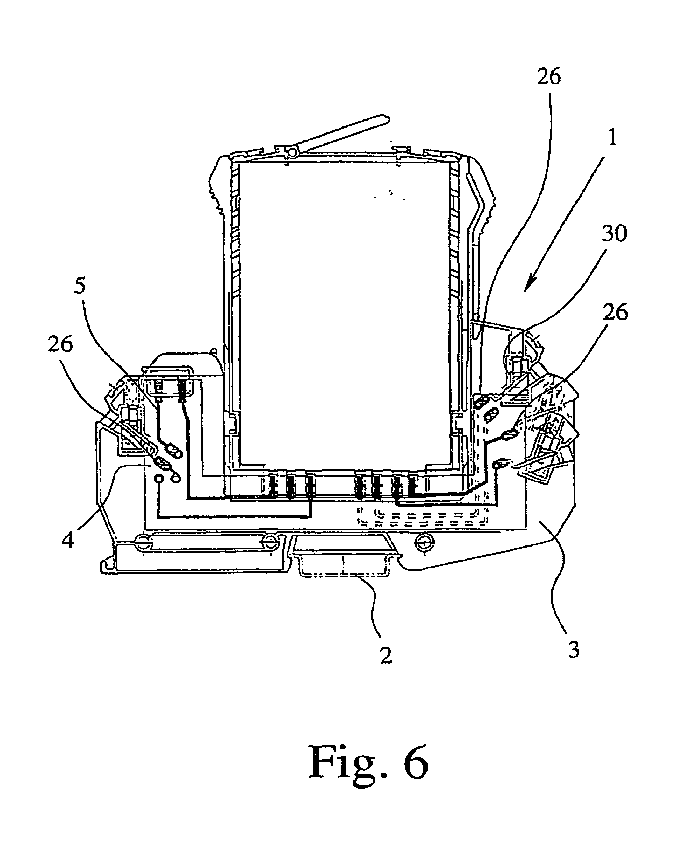

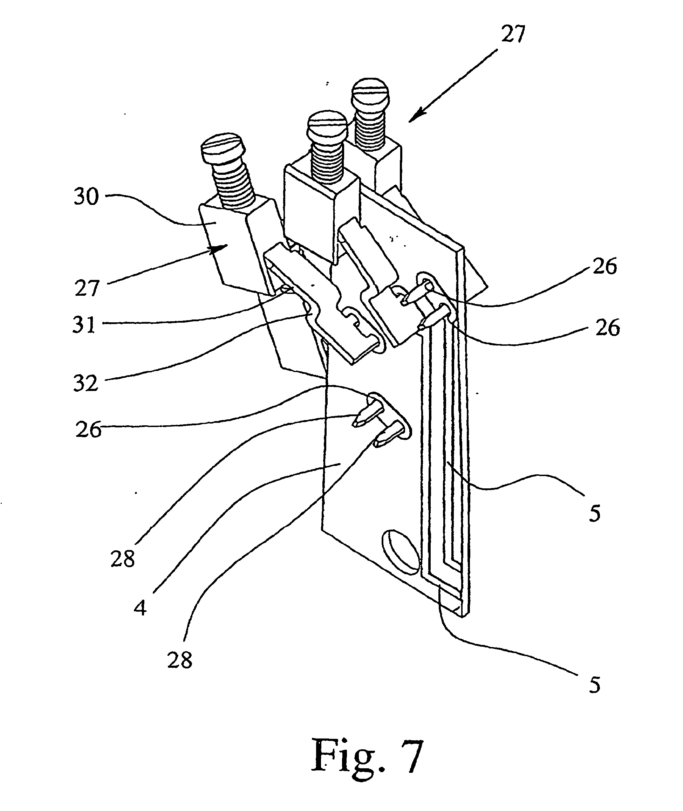

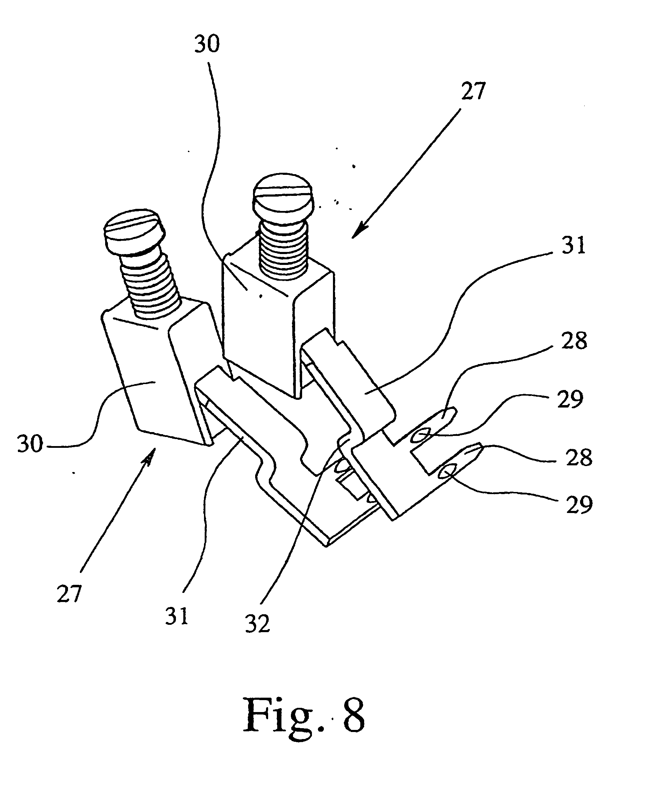

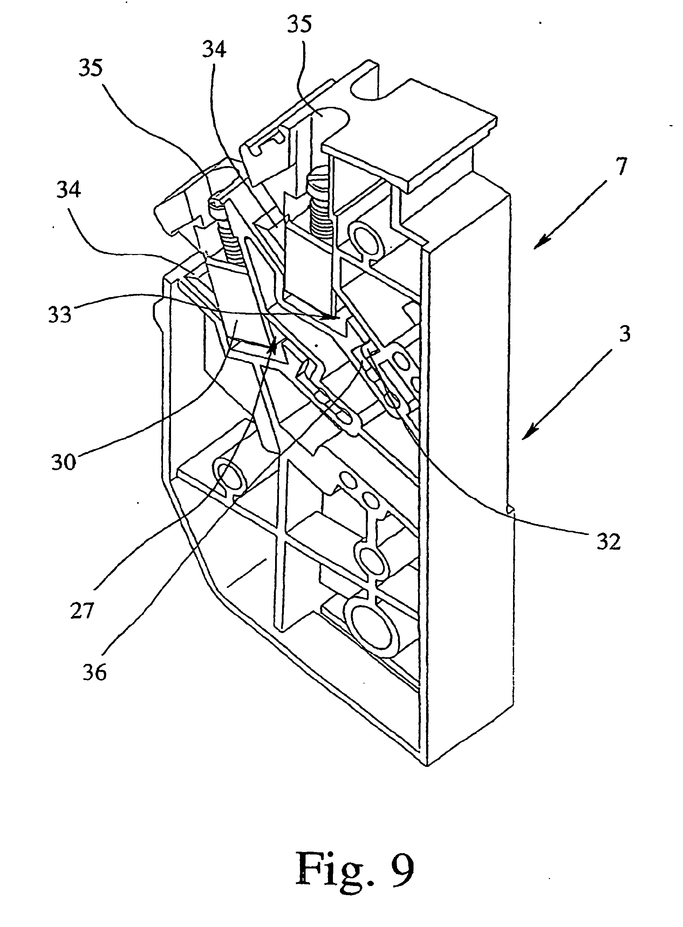

Die Leiterplatte 4 selbst ist im Gehäuse 3 bzw. im Oberteil 7 des Gehäuses 3 in einer Führung gehalten, die auch das Einschieben der Leiterplatte 4 beim Einbau erleichtert. Wie sich insbesondere aus den Fig. 5 bis 9 ergibt, sind in der Leiterplatte 4 und im Oberteil 7 jeweils korrespondierende Öffnungen 27 vorgesehen, die zum Einstekken wenigstens einer Fixiereinrichtung 27 von der Außenseite des Gehäuses 3 her dienen. Obwohl die Verwendung von Fixiereinrichtungen 27 natürlich besonders vorteilhaft in Verbindung mit den zweiteiligen Gehäusen 3 der erfindungsgemäßen Art ist, können die Fixiereinrichtungen 27 auch zum Fixieren der Leiterplatte 4 in einem einteiligen Gehäuse 3 vorgesehen sein, wie dies in Fig. 6 dargestellt ist. Die Verbindung der einzelnen Fixiereinrichtungen 27 mit der Leiterplatte 4 erfolgt lediglich über das Einstecken, ohne daß eine weitere Verbindung, insbesondere eine Verlötung erforderlich ist.

Zum Einstecken weist die Fixiereinrichtung 27 bei der in Fig. 5 dargestellten Ausführungsform einen Einsteckschenkel 28 auf, während bei den in den Fig. 6 bis 9 dargestellten Ausführungsformen jeweils zwei Einsteckschenkel 28 pro Fixiereinrichtung 27 vorgesehen sind. Die Einsteckschenkel 28 verlaufen etwa rechtwinklig zur Ebene der Leiterplatte 4 und damit koaxial zur Tragschienenrichtung R. Da die einzelnen Einsteckschenkel 28 lediglich in die Leiterplatte 4 eingesteckt sind, ist zur Verbesserung der Steckverbindung wenigstens eine Verdickung 29 am Einsteckschenkel 28 vorgesehen.

Neben ihrer Fixierungsfunktion dienen die einzelnen Fixiereinrichtungen 27 vorliegend aber auch zum Anschluß von Zuführungskontakten. Zu diesem Zweck ist am dem Einsteckschenkel 28 gegenüberliegenden Ende der Fixiereinrichtung 27 ein Klemmenelement 30 vorgesehen. Bei dem in den Fig. 6 bis 9 dargestellten Klemmenelement 30 handelt es sich vorliegend um eine Schraubklemme. Die Öffnungen 27 befinden sich jeweils im Bereich von Leiterbahnen 5, so daß sich beim Einstecken eines Einsteckschenkels 28 eine Kontaktierung mit der betreffenden Leiterbahn ergibt.

Der im Klemmenelement 30 vorhandene Kontaktschenkel ist aus dem Klemmenelement 30 als Schenkel 31 herausgeführt. Von dem Schenkel 31 etwa im rechten Winkel abgewinkelt sind die Einsteckschenkel 28. Vor der Abwinkelung der Einsteckschenkel 28 ist am Schenkel 31 eine Stufe 32 ausgebildet.

Die Fixiereinrichtungen 27 sind jeweils in korrespondierenden Aufnahmen 33 im Gehäuse 3 bzw. im Oberteil 7 des Gehäuses 3 aufgenommen. Zum Anschluß von Zuführungskontakten ist dabei für jede Fixiereinrichtung 27 eine Anschlußöffnung 34 und zur Betätigung des Klemmelements 30 jeweils eine Betätigungsöffnung 35 vorgesehen. Korrespondierend zur Stufe 32 am Schenkel 31 ist im übrigen in der Aufnahme 33 ein korrespondierender stufenförmiger Schlitz 36 vorgesehen, in dem die Stufe 32 am Gehäuse 3 anliegt, so daß etwaige Druck- und Zugbelastungen auf das Gehäuse 3 übertragen werden.

Um die Aufnahme 33 verschließen zu können, weist das Gehäuse 3 bzw. das Oberteil 7 eine Abdeckung 37 auf, die lösbar mit dem Gehäuse 3 bzw. dem Oberteil 7 verbunden, insbesondere mit diesem verrastet werden kann.

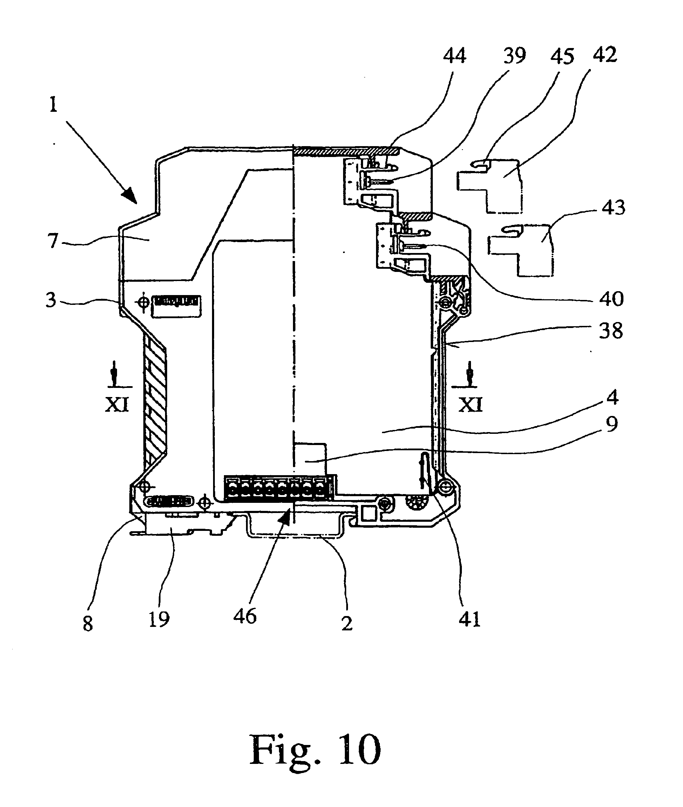

In den Fig. 10 bis 12 ist eine weitere Ausführungsform des Gerätes 1 dargestellt. Dieses Gerät 1 weist zu dem zuvor beschriebenen einige Gemeinsamkeiten, aber auch einige Unterschiede auf, auf die im folgenden näher eingegangen wird. Bei dem in den Fig. 10 bis 12 dargestellten Gerät 1 sind am Oberteil 7, und zwar an der einen Stirnseite 38, zwei Steckanschlüsse 39, 40 vorgesehen. Die Steckanschlüsse 39, 40 sind über eine elektrische Verbindung 41 mit der Leiterplatte 4 verbunden. Über die Steckanschlüsse 39, 40 lassen sich Erweiterungsmodule 42, 43 anschließen. Bei den Erweiterungsmodulen 42, 43 kann es sich um elektrische oder elektronische Geräte jeglicher Art handeln. Die Verbindung zwischen den Steckanschlüssen 39, 40 und den Erweiterungsmodulen 42, 43 erfolgt über korrespondierende Rasthaken 44, 45 und läßt sich von daher auch einfach wieder lösen.

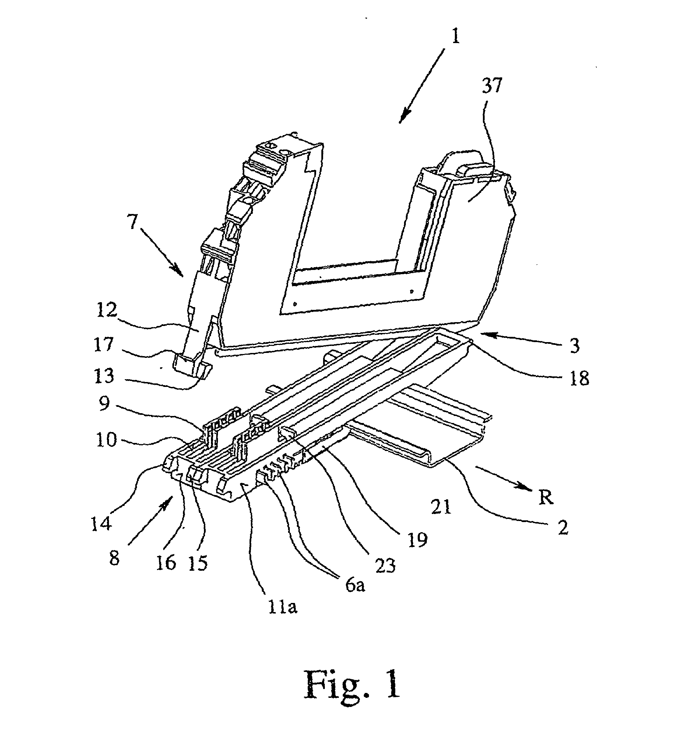

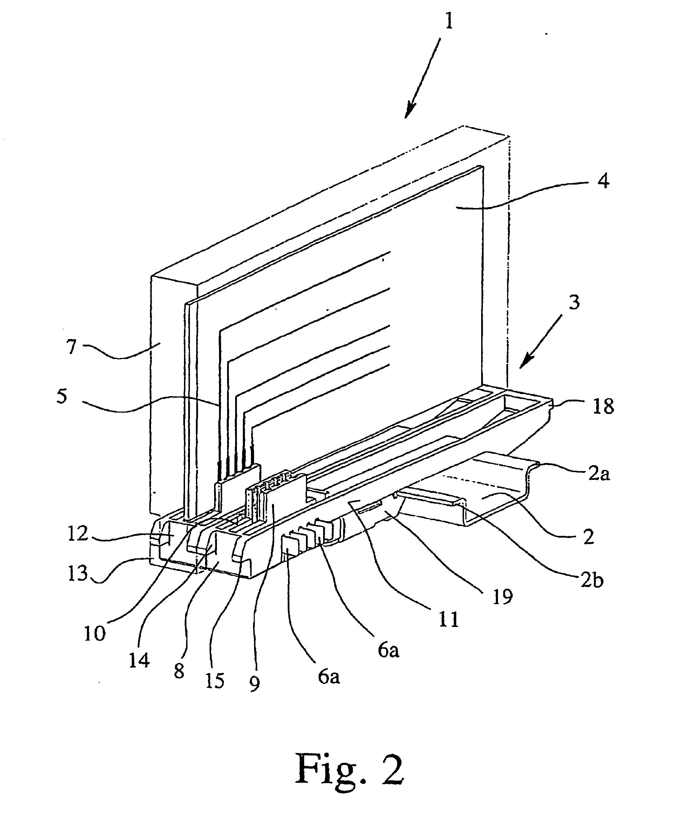

Im Gegensatz zu der Ausführungsform gemäß den Fig. 1 bis 9 ist hier die Leiterplattenaufnahme 9 nicht einteilig mit dem Sockelteil 8 ausgebildet, sondern an einem separaten Leiterplattenaufnahmekörper 46, der aus einem isolierenden Material besteht. Dieser Leiterplattenaufnahmekörper 46, in den die einzelnen Kontaktelemente mit den Buskontakten 6a, 6b eingesetzt sind, ist mit dem Sockelteil 8 fest verbunden. Hierbei kann jede Art von Verbindungs- und Befestigungsmitteln verwendet werden.

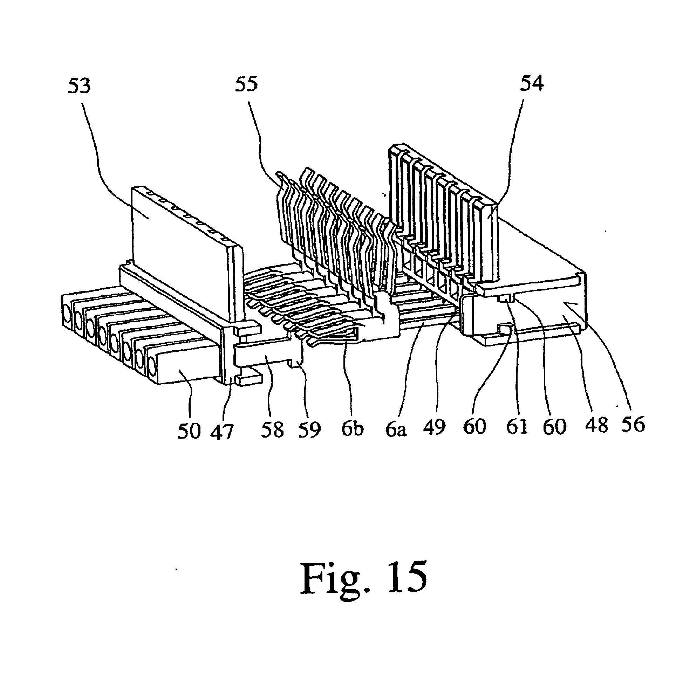

Wie sich insbesondere aus Fig. 15 ergibt, ist der Leiterplattenaufnahmekörper 46 zweiteilig ausgebildet und weist ein erstes Gehäuseteil 47 und ein zweites Gehäuseteil 48 auf. Zumindest im zweiten Gehäuseteil 48 befinden sich quer zur Leiterplattenaufnahmeebene E verlaufende Einsetzöffnungen 49, in die die Buskontakte 6b reibschlüssig einschiebbar sind. Es versteht sich, daß die nebeneinander angeordneten Kontaktelemente in den Einsetzöffnungen 49 gegeneinander isoliert sind.

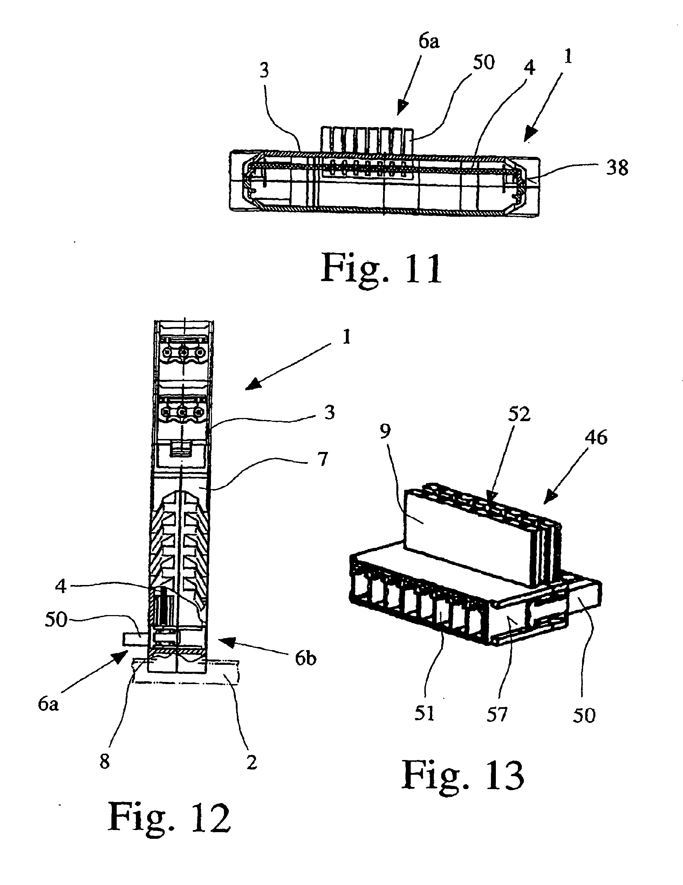

In Verlängerung der Einsetzöffnungen 49 sind am ersten Gehäuseteil 47 langgestreckte, über das Sockelteil 8 überstehende Verlängerungen 50 vorgesehen. Am zweiten Gehäuseteil 48 sind zu den Verlängerungen 50 korrespondierende Öffnungen 51 in Verlängerung der Einsetzöffnungen 49 vorgesehen. Wie sich insbesondere aus Fig. 12 ergibt, ragen die Buskontakte 6a, 6b nicht aus den Verlängerungen 50 und Öffnungen 51 heraus. Die Buskontakte 6a, 6b sind im in die Gehäuseteile 47, 48 eingesetzten Zustand gegeneinander und nach außen hin isoliert und können lediglich in Tragschienenlängsrichtung R kontaktiert werden. Daraus resultiert, daß die Verlängerungen 50 und die Öffnungen 51 derart ausgebildet sind. daß sich die Datenund/oder Energiebusverbindung nur Ineinanderschieben benachbarter Sockelteile 8 in Tragschienenlängsrichtung R ergibt. Ein Aufschwenken der Sockelteile 8 mit gleichzeitigem Kontaktieren, wie dies bei der Ausführungsform gemäß den Fig. 1 bis 9 vorgesehen ist, ist hierbei nicht möglich.

Die Leiterplattenaufnahme 9 weist in an sich bekannter Weise einen Leiterplattenaufnahmeschlitz 52 auf, in den die Leiterplatte 4 einsteckbar ist. Der Leiterplattenaufnahmeschlitz 52 wird von zwei parallel zueinander verlaufenden Wandungen 53, 54 gebildet, die einen etwa der Dicke der Leiterplatte 4 entsprechenden Abstand voneinander haben. Wie sich aus Fig. 15 ergibt, ist eine Wandung 53 am ersten Gehäuseteil 47 und die andere Wandung 54 am zweiten Gehäuseteil 48 vorgesehen. Die Aufteilung der Wandungen 53, 54 auf die beiden Gehäuseteile 47, 48 macht ein einfaches Einsetzen der Buskontakte 6a, 6b und auch eines zugehörigen Leiterplattenkontaktes 55 möglich. Bei der dargestellten Ausführungsform ist es so, daß die Buskontakte 6a, 6b und der Leiterplattenkontakt 55 einteilig ausgebildet sind und ein gemeinsames Kontaktelement bilden, das aus einem Blechstreifen durch entsprechende Stanzung und Biegung hergestellt worden ist. Bei den Buskontakten 6a handelt es sich vorliegend um Kontaktstifte, während die Buskontakte 6b jeweils zwei federnde Kontaktschenkel aufweisen, die zusammen schnabelartig ausgebildet sind. Die Leiterplattenkontakte 55 weisen ebenfalls jeweils zwei Kontaktschenkel auf, wobei diese Kontaktschenkel tulpenartig angeordnet sind.

Die beiden Gehäuseteile 47, 48 sind lösbar miteinander verbindbar. Hierzu dient eine Rastverbindung. Bei der dargestellten Ausführungsform ist an den beiden gegenüberliegenden Seiten 56, 57 des Leiterplattenaufnahmekörpers 46 eine Rastverbindung vorgesehen. Teil der Rastverbindung ist ein federnder Rastarm 58, der am ersten Gehäuseteil 47 vorgesehen ist. Der Rastarm 58 hat einen endseitigen Rasthaken 59. Am zweiten Gehäuseteil 48 sind hingegen zum Rasthaken 59 korrespondierende Rastvorsprünge 60 mit entsprechenden Auflaufschrägen 61 vorgesehen.

## Patentansprüche

1. Elektrisches oder elektronisches Gerät zum Aufsetzen auf eine Tragschiene (2), mit einem Gehäuse (3), mit wenigstens einer im Gehäuse (3) angeordneten Leiterplatte (4) und mit in Tragschienenlängsrichtung weisenden Buskontakten (6a, 6b) für eine Daten- und/oder Energiebusverbindung mit benachbarten, auf die Tragschiene (2) aufgesetzten und korrespondierende Buskontakte aufweisenden elektrischen oder elektronischen Geräten, wobei das Gehäuse (3) zumindest ein auf die Tragschiene (2) aufzusetzendes Sockelteil (8) und ein mit dem Sockelteil (8) lösbar verbindbares Oberteil (7) aufweist, wobei am Sockelteil (8) eine Leiterplattenaufnahme (9) und die Buskontakte (6a, 6b) vorgesehen sind, und wobei das Sockelteil (8) auf die Tragschiene (2) aufschwenkbar ist,
**dadurch gekennzeichnet, daß** bei abgenommenem Oberteil (7) die Leiterplatte (4) in der Leiterplattenaufnahme (9) angeordnet ist,
daß der eine Buskontakt (6a) auf der einen Seite (11a) als überstehender Messerkontakt und der andere Buskontakt (6b) auf der anderen Seite (11b) als doppelschenklige Kontaktaufnahme für den Messerkontakt ausgebildet sind und
daß am Sockelteil (8) oder an der Leiterplattenaufnahme (9) in die Kontaktaufnahme mündende, etwa vertikal verlaufende Schlitze (6c) vorgesehen sind, um ein Ein- und Ausschwenken eines Sockelteils (8) in die bzw. aus der Daten- und/oder Energieverbindung zu ermöglichen.

2. Elektrisches oder elektronisches Gerät nach Anspruch 1, **dadurch gekennzeichnet, daß** eine insbesondere rastbare erste Verriegelung zur lösbaren Verbindung des Oberteils (7) mit dem Sockelteil (8) vorgesehen ist.

3. Elektrisches oder elektronisches Gerät nach Anspruch 2, **dadurch gekennzeichnet. daß** die erste Verriegelung wenigstens einen federnden Rastarm (12) und zum Rastarm (12) korrespondierende Rasthaken (14. 15) aufweist und daß, vorzugsweise, der Rastarm (12) am Oberteil (7) und die Rasthaken (14, 15) am Sockelteil (8) vorgesehen sind.

4. Elektrisches oder elektronisches Gerät nach einem der Ansprüche 1 bis 3, **dadurch gekennzeichnet, daß** das Oberteil (7) auf das Sockelteil (8) aufschwenkbar ist und daß, vorzugsweise, die erste Verriegelung einen von der Außenseite des Gehäuses (3) manuell betätigbaren Griff- oder Eingriffsabschnitt am Rastarm (12) zum Lösen des Oberteils (7) vom Sockelteil (8) aufweist.

5. Elektrisches oder elektronisches Gerät nach einem der Ansprüche 1 bis 4, **dadurch gekennzeichnet, daß** eine zweite, insbesondere rastbare Verriegelung zur lösbaren Verbindung des Sockelteils (8) mit der Tragschiene (2) vorgesehen ist und daß, vorzugsweise, die zweite Verriegelung einen federbelasteten, am Sockelteil (8) verschiebbar gehaltenen Riegel (19) zum einseitigen Verriegeln der Tragschiene (2) aufweist.

6. Elektrisches oder elektronisches Gerät nach Anspruch 5, **dadurch gekennzeichnet, daß** der Riegel (19) im Bereich der Unterseite (20) des Sockelteils (8) vorgesehen ist, daß am Riegel (19) eine Betätigungsöffnung (22) und am Sockelteil (8) eine von der Oberseite (10) des Sockelteils (8) her zugängliche durchgehende Einführöffnung (23) für ein Werkzeug (24) vorgesehen sind und daß die Betätigungsöffnung (22) im verriegelten Zustand des Sockelteils (8) derart versetzt zur Einführöffnung (23) angeordnet ist, daß sich die Betätigungsöffnung (22) beim Einführen des Werkzeugs (24) vergrößert, der Riegel (19) entgegen der Federbelastung verschoben und das Sockelteil (8) freigegeben wird.

7. Elektrisches oder elektronisches Gerät nach Anspruch 6, **dadurch gekennzeichnet, daß** die Einführöffnung (23) nur bei abgenommenem Oberteil (7) zugänglich ist.

8. Elektrisches oder elektronisches Gerät nach einem der Ansprüche 1 bis 7, **dadurch gekennzeichnet, daß** in der Leiterplatte (4) und im Oberteil (7) jeweils korrespondierende Öffnungen (26) zum Einstecken wenigstens einer Fixiereinrichtung (27) von der Außenseite des Gehäuses (3) vorgesehen sind und daß, vorzugsweise, die Fixiereinrichtung (27) zur Verbindung mit der Leiterplatte (4) lediglich in diese eingesteckt ist, ohne weiter mit der Leiterplatte (4) verbunden zu sein.

9. Elektrisches oder elektronisches Gerät nach Anspruch 8. **dadurch gekennzeichnet, daß** die Fixiereinrichtung (27) wenigstens einen, vorzugsweise zwei in Tragschienenlängsrichtung (R) ausgerichtete Einsteckschenkel (28) aufweist und daß, vorzugsweise, am Einsteckschenkel (28) wenigstens eine Verdickung (29) vorgesehen ist.

10. Elektrisches oder elektronisches Gerät nach Anspruch 8 oder 9. **dadurch gekennzeichnet, daß** die Fixiereinrichtung (27) zum elektrischen Anschluß vorgesehen ist, daß die Fixiereinrichtung (27) wenigstens ein zumindest von einer Stirnseite des Oberteils zugängliches Klemmenelement (30) aufweist und daß der Einsteckschenkel (28) mit wenigstens einer Leiterbahn (5) der Leiterplatte (4) kontaktiert.

11. Elektrisches oder elektronisches Gerät nach einem der Ansprüche 8 bis 10, **dadurch gekennzeichnet, daß** die Fixiereinrichtung (27) in einer korrespondierenden Aufnahme (33) im Oberteil (7) aufgenommen ist und daß, im Oberteil (7) wenigstens eine Anschlußöffnung (34) und wenigstens eine Betätigungsöffnung (35) zum Klemmenelement (30) vorgesehen sind.

12. Elektrisches oder elektronisches Gerät nach Anspruch 10 oder 11, **dadurch gekennzeichnet, daß** die Fixiereinrichtung (27) einen aus dem Klemmenelement (30) herausragenden Schenkel (31) aufweist, von dem der Einsteckschenkel (28) absteht und daß am Schenkel (31) eine Stufe (32) und in der Aufnahme (33) ein korrespondierender stufenförmiger Schlitz (36) vorgesehen sind, in dem die Stufe (32) angeordnet ist und am Gehäuse (3) anliegt.

13. Elektrisches oder elektronisches Gerät nach Anspruch 11 oder 12, **dadurch gekennzeichnet, daß** eine Abdeckung (37) für die Aufnahme (33) vorgesehen ist und daß, die Abdeckung (37) lösbar mit dem Gehäuse (3) verbindbar, insbesondere verrastbar ist.

14. Elektrisches oder elektronisches Gerät nach einem der Ansprüche 1 bis 13. **dadurch gekennzeichnet daß** am Oberteil (7), insbesondere an wenigstens einer Stirnseite (38) zumindest ein mit der Leiterplatte (4) elektrisch verbundener Steckanschluß vorgesehen ist.

15. Elektrisches oder elektronisches Gerät zum Aufsetzen auf eine Tragschiene (2), mit einem Gehäuse (3), mit wenigstens einer im Gehäuse (3) angeordneten Leiterplatte (4) und mit in Tragschienenlängsrichtung (R) weisenden Buskontakten (6a, 6b) für eine Daten- und/oder Energiebusverbindung mit benachbarten, auf die Tragschiene (2) aufgesetzten und korrespondierende Buskontakte aufweisenden elektrischen oder elektronischen Geräten, wobei das Gehäuse (3) zumindest zweiteilig ausgebildet ist und ein die Leiterplatte (4) aufnehmendes Oberteil (7) und ein auf die Tragschiene (2) aufzusetzendes und die Buskontakte (6a, 6b) aufweisendes Sockelteil (8) mit einer Leiterplattenaufnahme (9) zur Kontaktierung der im Oberteil aufgenommenen Leiterplatte (4) vorgesehen sind, wobei ein die Leiterplattenaufnahme (9) aufweisender, separater und auf dem Sockelteil (8) zu befestigender Leiterplattenaufnahmekörper (46) aus elektrisch isolierendem Material vorgesehen ist, in den die Buskontakte (6a, 6b) eingesetzt sind,
**dadurch gekennzeichnet,**
**daß** der Leiterplattenaufnahmekörper (46) zumindest zweiteilig ausgebildet ist und ein erstes Gehäuseteil (47) und ein damit verbundenes zweites Gehäuseteil (48) aufweist, und
**daß** zumindest in einem Gehäuseteil (47, 48) quer zur Leiterplattenebene (E) verlaufende Einsetzöffnungen (49) zum form- und/oder reibschlüssigen Einsetzen der Buskontakte (6a, 6b) vorgesehen sind.

16. Elektrisches oder elektronisches Gerät nach Anspruch 15, **dadurch gekennzeichnet, daß** in Verlängerung der Einsetzöffnungen (49) an dem ersten Gehäuseteil (47) langgestreckte, über das Sockelteil (8) überstehende Verlängerungen (50), in denen sich die einen Buskontakte (6b) befinden, und am zweiten Gehäuseteil (48) korrespondierende Öffnungen (51), in denen sich die anderen Buskontakte (6a) befinden, vorgesehen sind, und daß die Verlängerungen (50) und die Öffnungen (51) derart ausgebildet sind, daß sich die Daten- und/oder Energiebusverbindung durch Ineinanderschieben benachbarter Sockelteile (8) in Tragschienenlängsrichtung (R) ergibt.

17. Elektrisches oder elektronisches Gerät nach Anspruch 15 oder 16. **dadurch gekennzeichnet, daß** die Leiterplattenaufnahme (9) einen Leiterplattenaufnahmeschlitz (52) mit zwei parallel zueinander verlaufenden Wandungen (53. 54) aufweist und daß eine Wandung (53) am ersten Gehäuseteil (47) und die andere Wandung (54) am zweiten Gehäuseteil (48) vorgesehen ist.

18. Elektrisches oder elektronisches Gerät nach einem der Ansprüche 1 bis 17, **dadurch gekennzeichnet, daß** die Buskontakte (6a, 6b) mit einem Leiterplattenaufnahmekontakt (55) verbunden sind, und daß, vorzugsweise, die Buskontakte (6a, 6b) und der Leiterplattenkontakt (55) aus einem zusammenhängenden Stück aus elektrisch leitendem Material hergestellt sind.

19. Elektrisches oder elektronisches Gerät nach einem der Ansprüche 15 bis 18, **dadurch gekennzeichnet, daß** eine Rastverbindung zur lösbaren Verbindung des ersten Gehäuseteils (47) mit dem zweiten Gehäuseteil (48) vorgesehen ist, und daß an den beiden Stirnseiten (56, 57) des Leiterplattenaufnahmekörpers (46) wenigstens jeweils ein federnder Rastarm (58) mit Rasthaken (59) und zum Rasthaken (59) korrespondierende Rastvorsprünge (60) vorgesehen sind.

## Claims

1. An electrical or electronic device to be placed on a mounting rail (2), with a casing (3), with at least one printed circuit board (4) arranged inside the casing (3), and with bus contacts (6a, 6b) pointing in the longitudinal direction of the mounting rail for a data and/or energy bus connection with adjacent electrical or electronic devices that have corresponding bus contacts and are placed on the mounting rail (2),
wherein the casing (3) has at least one socket section (8) to be placed on the mounting rail (2) and an upper section (7) detachably connectable with the socket section,
wherein a printed circuit board receptacle (9) and the bus contacts (6a, 6b) are provided on the socket section (8), and wherein the socket section (8) can be swiveled up on the mounting rail (2),
**characterized in that**
the printed circuit board (4) is arranged in the printed circuit board receptacle (9) with the upper section (7) removed,
that the one bus contact (6a) on the one side (11 a) is designed as a projecting blade contact, while the other bus contact (6b) on the other side (11b) is designed as a double-leg contact receptacle for the blade contact, and
that roughly vertical slits (6c) that lead into the contact receptacle are provided on the socket section (8) or in the printed circuit board receptacle (9), so that the socket section (8) can be swiveled into or out of the data and/or energy bus connection.

2. The electrical or electronic device according to claim 1, **characterized in that** an in particular latching first interlock is provided for detachably connecting the upper section (7) with the socket section (8).

3. The electrical or electronic device according to claim 2, **characterized in that** the first interlock has at least one resilient latching arm (12) and latching hooks (14, 15) corresponding to the latching arm (12), and that, preferably, the latching arm (12) is provided on the upper section (7), and the latching hooks (14, 15) are provided on the socket section (8).

4. The electrical or electronic device according to one of claims 1 to 3, **characterized in that** the upper section (7) can be swiveled up on the socket section (8), and that, preferably, the first interlock has a gripping or engaging segment on the latching arm (12) that can be manually actuated from the outside of the casing (3) to detach the upper section (7) from the socket section (8).

5. The electrical or electronic device according to one of claims 1 to 4, **characterized in that** a second, in particular latching interlock is provided for detachably connecting the socket section (8) with the mounting rail (2), and that, preferably, the second interlock has a spring-loaded, sliding bolt (19) on the socket section (8) for unilateral locking to the mounting rail (2).

6. The electrical or electronic device according to claim 5, **characterized in that** the bolt (19) is provided in the area of the bottom (20) of the socket section (8), that the bolt (19) is provided with an actuation opening (22), while the socket section (8) is provided with a continuous entry opening (23) for a tool (24), for example a screwdriver, which is accessible from the upper side (10) of the socket section (8), and that the actuator opening (22) is offset relative to the entry opening (23) in the locked state of the socket section (8) in such a way that the actuator opening (22) enlarges as the tool (24) is introduced, while the bolt (19) is moved against the spring loading and the socket section (8) is released.

7. The electrical or electronic device according to claim 6, **characterized in that** the entry opening (23) can only be accessed with the upper section (7) removed.

8. The electrical or electronic device according to one of claims 1 to 7, **characterized in that** respectively corresponding openings (26) are provided in the printed circuit board (4) and the upper section (7) for inserting at least one fixing device (27) from the outside of the casing (3), and that, preferably, the fixing device (27) used for connection with the printed circuit board (4) is only inserted into the latter without being additionally connected with the printed circuit board (4).

9. The electrical or electronic device according to claim 8, **characterized in that** the fixing device (27) has at least one, but preferably two insertion legs (28) oriented in the longitudinal direction of the mounting rail (R), and that, preferably, the insertion leg (28) has at least one thickened area (29).

10. The electrical or electronic device according to claim 8 or 9, **characterized in that** the fixing device (27) is provided for establishing an electrical connection, that the fixing device (27) has at least one clamping element (30) accessible at least from a face of the upper section, and that the insertion leg (28) contacts at least one printed conductor (5) of the printed circuit board (4).

11. The electrical or electronic device according to one of claims 8 to 10, **characterized in that** the fixing device (27) is incorporated in a corresponding receptacle (33) in the upper section (7), and that the upper section (7) incorporates at least one connection opening (34) and at least one actuator opening (35) for the clamping element (30).

12. The electrical or electronic device according to claim 10 or 11, **characterized in that** the fixing device (27) has a leg (31) projecting out of the clamping element (30), from which the insertion leg (28) extends, and that the leg (31) is provided with a step (32), and the receptacle (33) incorporates a corresponding, stepped slit (36), in which the step is arranged (32) and abuts the casing (3).

13. The electrical or electronic device according to claim 11 or 12, **characterized in that** a cover (37) is provided for the receptacle (33), and that the cover (37) can be detachably connected, in particular latched, with the casing (3).

14. The electrical or electronic device according to one of claims 1 to 13, **characterized in that** at least one plug-in connection electrically connected with the printed circuit board (4) is provided on the upper section (7), in particular on at least one face (38).

15. An electrical or electronic device to be placed on a mounting rail (2), with a casing (3), with at least one printed circuit board (4) arranged inside the casing (3), and with bus contacts (6a, 6b) pointing in the longitudinal direction (R) of the mounting rail (2) for a data and/or energy bus connection with adjacent electrical or electronic devices that have corresponding bus contacts and are placed on the mounting rail (2), wherein the casing (3) is designed in at least two parts, and an upper section (7) that accommodates the printed circuit board (4), and a socket section (8) that is to be placed on the mounting rail (2) and has the bus contacts (6a, 6b), which incorporates a printed circuit board receptacle (9) for contacting the printed circuit board (4) accommodated in the upper section (7) are provided,
wherein a separate printed circuit board receptacle body (46) made out of electrically insulating material is provided, which has the printed circuit board receptacle (9) and which is to be attached to the socket section (8), into which the bus contacts (6a, 6b) are inserted,
**characterized in that**
the printed circuit board receptacle body (46) is designed in two parts, and has a first casing section (47) and a second casing section (48) connected thereto,
and that insertion openings (49) for the positive and/or non-positive insertion of the bus contacts (6a, 6b) are provided transverse to the printed circuit board plane (E) in at least one casing section (47, 48).

16. The electrical or electronic device according to claim 15, **characterized in that** the insertion openings (49) are extended by providing the first casing section (47) with long, stretched-out elongations (50) that contain the one bus contacts (6b) and project over the socket section (8), while the second casing section (48) accommodates corresponding openings (51) in which the other bus contacts are situated (6a), and that the openings (51) are designed in such a way that telescoping adjacent socket sections (8) in the longitudinal direction of the mounting rail (R) results in a data and/or energy bus connection.

17. The electrical or electronic device according to claim 15 or 16, **characterized in that** the printed circuit board receptacle (9) has a printed circuit board receptacle slit (52) with two walls (53, 54) running parallel to each other, and that one wall (53) is provided on the first casing section (47), and the other wall (54) on the second casing section (48).

18. The electrical or electronic device according to one of claims 1 to 17, **characterized in that** the bus contacts (6a, 6b) are connected with a printed circuit board receptacle contact (55), and that, preferably, the bus contacts (6a, 6b) and the printed circuit board contact (55) are fabricated out of an assembled piece comprised of electrically conductive material.

19. The electrical or electronic device according to one of claims 15 to 18, **characterized in that** a latching connection for detachably connecting the first casing section (47) with the second casing section (48) is provided, and that both faces (56, 57) of the printed circuit board receptacle body (46) are each provided with at least one resilient latching arm (58) with latching hook (59), and latching projections (60) corresponding to the latching hook (59).

## Revendications

1. Appareil électrique ou électronique à poser sur un rail porteur (2), avec un boîtier (3), avec au moins une carte imprimée (4) disposée dans le boîtier (3) et avec des contacts de bus (6a, 6b) dirigés dans le sens longitudinal du rail porteur pour une liaison de bus de données et/ou une liaison de bus d'énergie avec des appareils électriques ou électroniques voisins, posés sur le rail porteur (2) et présentant des contacts de bus correspondants, le boîtier (3) présentant au moins une partie de socle (8) à poser sur le rail porteur (2) et une partie supérieure (7) pouvant être reliée de façon amovible avec la partie de socle (8), un logement de carte imprimée (9) et les contacts de bus (6a, 6b) étant prévus sur la partie de socle (8), et la partie de socle (8) peut basculer sur le rail porteur (2),
**caractérisé en ce que**
la carte imprimée (4) étant disposée dans le logement de carte imprimée (9) avec la partie supérieure (7) enlevée, et
**en ce qu'**un contact de bus (6a) est conçu sur un côté (11a) comme un contact à couteau débordant et l'autre contact de bus (6b) sur l'autre côté (11b) comme logement de contact à double branche pour le contact à couteau, et
**en ce qu'**il est prévu sur une partie de socle (8) ou sur le logement de carte imprimée (9) des fentes (6c) débouchant dans le logement de contact et agencées à peu près verticalement, afin de permettre un basculement vers l'intérieur et l'extérieur d'une partie de socle (8) dans la liaison de données et/ou la liaison d'énergie.

2. Appareil électrique ou électronique selon la revendication 1, **caractérisé en ce qu'**il est prévu un premier verrouillage, en particulier pouvant être encliqueté, pour la liaison amovible de la partie supérieure (7) avec la partie de socle (8).

3. Appareil électrique ou électronique selon la revendication 2, **caractérisé en ce que** le premier verrouillage présente au moins un bras à encliquetage (12) monté sur ressort et des crochets à encliquetage (14, 15) correspondant au bras à encliquetage (12), et **en ce que**, de préférence, le bras à encliquetage (12) et les crochets à encliquetage (14, 15) sont prévus et respectivement sur la partie supérieure (7) et sur la partie de socle (8).

4. Appareil électrique ou électronique selon l'une quelconque des revendications 1 à 3, **caractérisé en ce que** la partie supérieure (7) peut être basculée sur la partie de socle (8) et **en ce que**, de préférence, le premier verrouillage présente une partie de poignée ou d'engrènement, pouvant être actionnée manuellement par le côté extérieur du boîtier (3), sur le bras à encliquetage (12) pour le desserrement de la partie supérieure (7) de la partie de socle (8).

5. Appareil électrique ou électronique selon l'une quelconque des revendications 1 à 4, **caractérisé en ce qu'**il est prévu un second verrouillage, en particulier encliquetable, pour la liaison amovible de la partie de socle (8) avec le rail porteur (2) et **en ce que**, de préférence, le second verrouillage présente un verrou (19) chargé par ressort et maintenu de façon coulissante sur la partie de socle (8) pour le verrouillage unilatéral du rail porteur (2).

6. Appareil électrique ou électronique selon la revendication 5, **caractérisé en ce que** le verrou (19) est prévu dans la zone du côté inférieur (20) de la partie de socle (8), **en ce qu'**un orifice d'actionnement (22) et un orifice d'introduction (23) continu, accessible par le côté supérieur (10) de la partie de socle (8), pour un outil sont prévus respectivement sur le verrou (19) et sur la partie de socle (8) et **en ce que** l'orifice d'actionnement (22) est disposé de façon décalée par rapport à l'orifice d'introduction (23) dans l'état verrouillé de la partie de socle (8), de telle sorte que l'orifice d'actionnement (22) s'agrandit lors de l'introduction de l'outil (24), le verrou (19) est déplacé dans le sens contraire à la charge du ressort et la partie de socle (8) est libérée.

7. Appareil électrique ou électronique selon la revendication 6, **caractérisé en ce que** l'orifice d'introduction (23) est accessible seulement lorsque la partie supérieure (7) est enlevée.

8. Appareil électrique ou électronique selon l'une quelconque des revendications 1 à 7, **caractérisé en ce qu'**il est prévu dans la carte imprimée (4) et dans la partie supérieure (7) des orifices (26) qui se correspondent pour l'emboîtement d'au moins un dispositif de fixation (27) par le côté extérieur du boîtier (3) et **en ce que**, de préférence, le dispositif de fixation (27) est emboîté uniquement dans la carte imprimée (4) pour la liaison avec celle-ci sans être relié également à la carte imprimée (4).

9. Appareil électrique ou électronique selon la revendication 8, **caractérisé en ce que** le dispositif de fixation (27) présente au moins, de préférence deux branches d'emboîtement (28) orientées dans le sens longitudinal du rail porteur (R) et **en ce que**, de préférence, il est prévu au moins une surépaisseur (29) sur la branche d'emboîtement (28).

10. Appareil électrique ou électronique selon la revendication 8 ou 9, **caractérisé en ce que** le dispositif de fixation (27) est prévu pour le raccordement électrique, **en ce que** le dispositif de fixation (27) présente au moins un élément de borne (30) accessible au moins par un côté avant de la partie supérieure et **en ce que** la branche d'emboîtement (28) est en contact avec au moins une piste conductrice (5) de la carte imprimée (4).

11. Appareil électrique ou électronique selon l'une quelconque des revendications 8 à 10, **caractérisé en ce que** le dispositif de fixation (27) est réceptionné dans un logement (33) correspondant dans la partie supérieure (7) et **en ce qu'**il est prévu dans la partie supérieure (7) au moins un orifice de raccordement (34) et au moins un orifice d'actionnement (35) pour l'élément de borne (30).

12. Appareil électrique ou électronique selon la revendication 10 ou 11, **caractérisé en ce que** le dispositif de fixation (27) présente une branche (31) débordant de l'élément de borne (30), de laquelle elle dépasse la branche d'emboîtement (28) et **en ce qu'**il est prévu sur la branche (31) un étage (32) et dans le logement (33) une fente (36) en forme d'étage est correspondante, dans laquelle l'étage (32) est disposé et est contigu au boîtier (3).

13. Appareil électrique ou électronique selon la revendication 11 ou 12, **caractérisé en ce qu'**il est prévu un revêtement (37) pour le logement (33) et **en ce que** le revêtement (37) peut être relié de façon amovible au boîtier (3), en particulier peut être encliqueté.

14. Appareil électrique ou électronique selon l'une quelconque des revendications 1 à 13, **caractérisé en ce qu'**il est prévu au moins un branchement d'emboîtement relié de façon électrique à la carte imprimée (4) sur la partie supérieure (7) en particulier sur au moins un côté avant (38).

15. Appareil électrique ou électronique (1) à poser sur un rail porteur (2), avec un boîtier (3), avec au moins une carte imprimée (4) disposée dans le boîtier (3) et avec des contacts de bus (6a, 6b) dirigés dans le sens de la longueur (R) du rail porteur (2) pour une liaison de bus de données et/ou une liaison de bus d'énergie avec des appareils électriques ou électroniques voisins, posés sur le rail porteur (2) et présentant des contacts de bus correspondants, le boîtier (3) étant conçu au moins en deux parties, et une partie supérieure (7) recevant la carte imprimée (4) et une partie de socle (8) à poser sur le rail porteur (2) et présentant les contacts de bus (6a, 6b) avec un logement de carte imprimée (9) pour le contact de la carte imprimée (4) réceptionnée dans la partie supérieure (7) étant prévu, et
un corps de logement de carte imprimée (46) présentant le logement de carte imprimée (9) est prévu, séparé et à fixer sur la partie de socle (8), à base de matériau électro-isolant, dans lequel les contacts de bus (6a, 6b) sont insérés,
**caractérisé en ce que**
le corps de logement de carte imprimée (46) est conçu au moins en deux parties et présente une première partie de boîtier (47) et une seconde partie de boîtier (48) reliée à la première et
**en ce que**, au moins dans une partie de boîtier (47, 48), il est prévu des orifices d'insertion (49) agencés transversalement au plan de la carte imprimée (E) pour l'insertion par conjugaison de forme et/ou par adhérence de friction des contacts de bus (6a, 6b).

16. Appareil électrique ou électronique selon la revendication 15, **caractérisé en ce qu'**il est prévu dans le prolongement des orifices d'insertion (49) sur la première partie du boîtier (47) des prolongements (50) étirés en longueur et débordant de la partie de socle (8), dans lesquels se trouvent les premiers contacts de bus (6b), et sur la seconde partie de boîtier (48) des orifices (51) correspondants, dans lesquels se trouvent les autres contacts de bus (6a), et **en ce que** les prolongements (50) et les orifices (51) sont conçus de telle sorte qu'on obtient la liaison de bus de données et/ou la liaison de bus d'énergie par l'emboîtement de parties de socle (8) voisines dans le sens longitudinal du rail porteur (R).

17. Appareil électrique ou électronique selon la revendication 15 ou 16, **caractérisé en ce que** le logement de carte imprimée (9) présente une fente de logement de carte imprimée (52) avec deux parois (53, 54) parallèles entre elles et **en ce qu'**une paroi (53) est prévue sur la première partie du boîtier (47) et l'autre paroi (54) sur la seconde partie du boîtier (48).

18. Appareil électrique ou électronique selon l'une quelconque des revendications 1 à 17, **caractérisé en ce que** les contacts de bus (6a, 6b) sont reliés à un contact de logement de carte imprimée (55) et **en ce que**, de préférence, les contacts de bus (6a, 6b) et le contact de cartes imprimées (55) sont fabriqués à partir d'un morceau continu à base de matériau électro-conducteur.

19. Appareil électrique ou électronique selon l'une quelconque des revendications 15 à 18, **caractérisé en ce qu'**il est prévu une liaison par encliquetage pour La liaison amovible de la première partie du boîtier (47) avec la seconde partie du boîtier (48), et **en ce que**, sur chacun des deux cotés avant (56, 57) du corps de logement de carte imprimée (46), il est prévu au moins un bras à encliquetage (58) monté sur ressort avec un crochet à encliquetage (59) et des saillies d'encliquetage (60) correspondant au crochet à encliquetage (59).
